Europäisches Patentamt

European Patent Office

Office européen des brevets

(19)

(11) Veröffentlichungsnummer: **0 000 326**
**B1**

(12) **EUROPÄISCHE PATENTSCHRIFT**

(21) Anmeldenummer: 78100081.5

(22) Anmeldetag: 02.06.78

(51) Int. Cl.³: **H 01 L 21/00,**
**H 01 L 21/82,**
**H 01 L 21/314**

(54) Verfahren zum Herstellen sehr kleiner, mit Störstellen versehener Zonen in einem Halbleitersubstrat

(30) Priorität: 12.07.77 US 814829

(43) Veröffentlichungstag der Anmeldung:
24.01.79 Patentblatt 79/02

(45) Bekanntmachung des Hinweises auf die Patenterteilung:
17.09.80 Patentblatt 80/19

(84) Benannte Vertragsstaaten:
DE FR GB

(56) Entgegenhaltung:
FR - A - 2 130 397

(73) Patentinhaber: International Business Machines
Corporation
Armonk, N.Y. 10504 (US)

(72) Erfinder: Feng, Bai-Cwo
7F White Gates Apts.
Wappingers Falls, NY 12590 (US)
Feng, George Cheng-Cwo
164 South Avenue
Poughkeepsie, NY 12601 (US)

(74) Vertreter: Böhmer, Hans Erich, Dipl.-Ing.
Schönaicher Strasse 220
D - 7030 Böblingen (DE)

# Verfahren zum Herstellen sehr kleiner, mit Störstellen versehener Zonen in einem Halbleitersubstrat

Die Erfindung betrifft ein Verfahren zum Herstellen einer mit einem Störelement dotierten Zone innerhalb eines gewünschten Bereichs der Oberfläche eines Halbleitersubstrats durch Bilden einer aus einer unteren und einer oberen Schicht bestehenden ersten Maskenschicht, deren Materialien selektiv ätzbar sind, und durch Ätzen einer ersten den vorerwähnten Bereich definierenden Öffnung in der ersten Maskenschicht in der Weise, daß ein Teil der oberen Schicht einen Überhang über der unteren Schicht bildet.

*Beschreibung des Standes der Technik*

Ein Problem, das beim Entwurf von Halbleiterschaltungen eine wesentliche Erhöhung der Anzahl von Transistoren, die innerhalb eines Halbleiterplättchens hergestellt werden können, verhindert hat, ist die Ausrichtung einer mit Störstellen dotierten Zone mit einer anderen ebensolchen Zone. Mit der Verfeinerung der fotografischen und mit Elektronenstrahl arbeitenden lithographischen Verfahren hat man eine wesentliche Verkleinerung der geometrischen Abmessungen der aktiven Zonen oder Bereiche innerhalb eines Halbleiterplättchens erzielen können. Die Schwierigkeiten bei der Ausrichtung von Masken hat jedoch eine volle Ausnutzung der darin liegenden Möglichkeiten verhindert.

Die heute allgemein gebräuchlichen Verfahren zum Ausrichten benutzen auf der Maske und im darunter liegenden Halbleitersubstrat Ausrichtmarken. Diese Marken werden durch erfahrene Bedienungskräfte von Hand miteinander ausgerichtet. Mit abnehmender Größe der einzelnen Bauelemente und Halbleiterschaltungen nimmt die Möglichkeit von Ausrichtfehlern zu. Auch ist dieses Verfahren wesentlich teuerer, als eine in einem Fertigungsverfahren sich von selbst ergebende Ausrichtung, da nämlich jede Maske für sich ausgerichtet werden muß.

Erst kürzlich ist man beim Entwurf von Halbleiterschaltungen dazu übergegangen, selbstausrichtende Maskenverfahren einzusetzen, wobei dann Sperrmasken benutzt wurden, die die Notwendigkeit einer vollkommenen Maskenausrichtung bei jedem Schritt umgeht. Die US-Patentschriften 3 928 082, 3 948 694, 3 967 981 und die der Anmelderin gehörende US-Patentschrift 3 900 352 sind Beispiele für eine solche, sich von selbst ergebende Ausrichtung. Jedoch ist eine Anwendung dieser Verfahren in der Fertigung entweder durch die erforderliche Ionen-Implantation von einem oder mehreren Störelementen in Bereichen durch eine Maske oder deswegen beschränkt, weil sie sich nur für die Herstellung von auf Abstand liegenden Zonen eignen.

In der FR—A 2 130 397, die der DE—OS 22 12 049 entspricht, ist ein Verfahren zum Ausrichten einer mit Störelementen dotierten Zone innerhalb einer anderen solchen Zone mit Hilfe einer aus zwei in bezug aufeinander selektiv ätzbare Teilschichten bestehende Maskenschicht offenbart, wobei hier die Ausrichtung der beiden Zonen miteinander durch eine durch Unterätzung erzielte Unterschneidung erreicht wird.

Eine Schwierigkeit, die bisher beim Entwurf und bei der Herstellung von Halbleiterschaltungen durch bekannte Verfahren nicht richtig erkannt wurde, ist das seitliche Unterschneiden einer Maskenschicht, die während eines Ätzverfahrens unter einer anderen Maskenschicht liegt. Dieses Unterätzen vergrößert die effektive Größe der Öffnung in der Maske für das Eindringen von Störelementen und kann ein Überlappen von Zonen zur Folge haben, die an sich getrennt sein sollten.

*Gesamtdarstellung der Erfindung:*

Aufgabe der Erfindung ist es daher, ein verbessertes Verfahren zum selbstausrichtenden Eindringen eines Störelementes in a) ein Halbleitersubstrat oder in b) einen anderen mit Störelementen dotierten Bereich innerhalb des Substrats anzugeben. Insbesondere soll es dadurch möglich werden, zwei oder mehr mit Störelementen dotierte Zonen innerhalb eines Substrates oder einer anderen mit Störelementen dotierten Zone herzustellen, wobei diese zwei oder mehr Zonen von selbst miteinander ausgerichtet sind.

Diese der Erfindung zugrunde liegende Aufgabe wird dadurch gelöst, daß man die während des Ätzens einer zusammengesetzten Maske aus beispielsweise Siliciumnitrid und Siliciumdioxid sich ergebende Unterschneidung oder Unterätzung mit Vorteil ausnutzt. Im vorliegenden Fall wird diese Unterschneidung oder Unterätzung dazu benutzt sicherzustellen, daß zwischen dem Umfang einer mit Störelementen dotierten Zone und einer anderen, d.h. beispielsweise der Emitter- und der Basiszone eines planaren Transistors ein vorbestimmter kleinster Abstand eingehalten wird.

Die Ausgangsposition für die Erfindung besteht zunächst darin daß man auf der Oberfläche eines Substrats eine erste Maskenschicht herstellt, die aus einem unteren und einem oberen Material besteht, die in bezug aufeinander selektiv ätzbar sind, daß anschließend innerhalb der ersten Maskenschicht zunächst eine erste Öffnung in der Weise geätzt wird, daß ein Teil der oberen Schicht am Umfang der ersten Öffnung einen Überhang über der unteren Schicht bildet. Dann wird innerhalb der ersten Öffnung eine zweite Maskenschicht gebildet, die eine Schicht eines Materials einschließt, das mit dem gleichen Ätzmittel ätzbar ist wie die obere Schicht, so daß der Überhang mindestens teilweise ausgefüllt ist und das gesamte mit dem gleichen Ätzmaterial ätzbare Material innerhalb der Öffnung dünner ist als an ihrem Umfang. Anschließend wird innerhalb der ersten Öffnung mittels einer Sperrmaske durch die zweite Maskenschicht hindurch eine zweite Öffnung geätzt, worauf durch diese zweite Öffnung zur Bildung einer dotieren Zone ein Störelement eingeführt wird.

In der bevorzugten Ausführungsform wird die Unterschneidung bis auf etwa 0.7 Micrometer geätzt. Vor Herstellung der zweiten Maskenschicht wird innerhalb der ersten Öffnung eine Basiszone gebildet. Innerhalb der zweiten Öffnung wird dann eine Emitterzone gebildet. Wenn alles in dieser Weise ausgeführt wird, so erhält man einen Abstand zwischen dem Umfang der Emitterzone und dem Umfang der Basiszone von etwa 0.7 Micrometer, so daß auf diese Weise eine selbsttätige Ausrichtung sichergestellt ist.

Ein vorteilhaftes weiteres Merkmal der Erfindung besteht darin, daß innerhalb der Basiszone mehr als eine Zone gebildet werden kann. Beispielsweise können Emitter- und Basiskontakte lediglich durch Verwendung einer Sperrmaske mit selbsttätiger Ausrichtung hergestellt werden.

Die Erfindung wird nunmehr anhand eines Ausführungsbeispiels in Verbindung mit den beigefügten Zeichnungen im einzelnen beschrieben.

In den Zeichnungen zeigen

Fign. 1A—1J Querschnittsansichten eines Halbleiterbauelementes bei verschiedenen Fertigungsstufen mit einem Verfahren gemäß der Erfindung,

Fig. 2 eine Draufsicht auf ein Halbleiterbauelement, bie der in Fig. 1J dargestellten Verfahrensstufe.

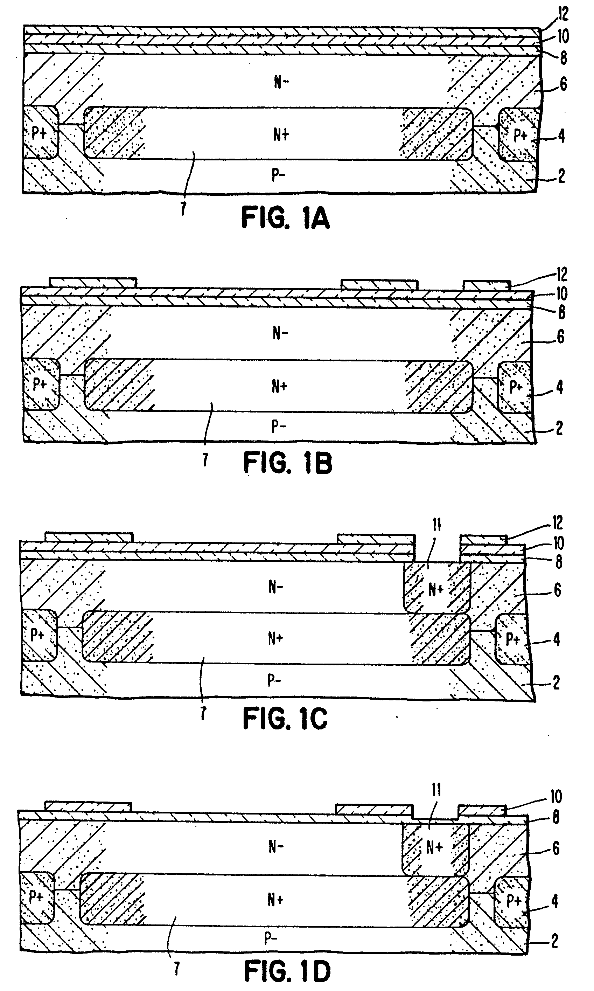

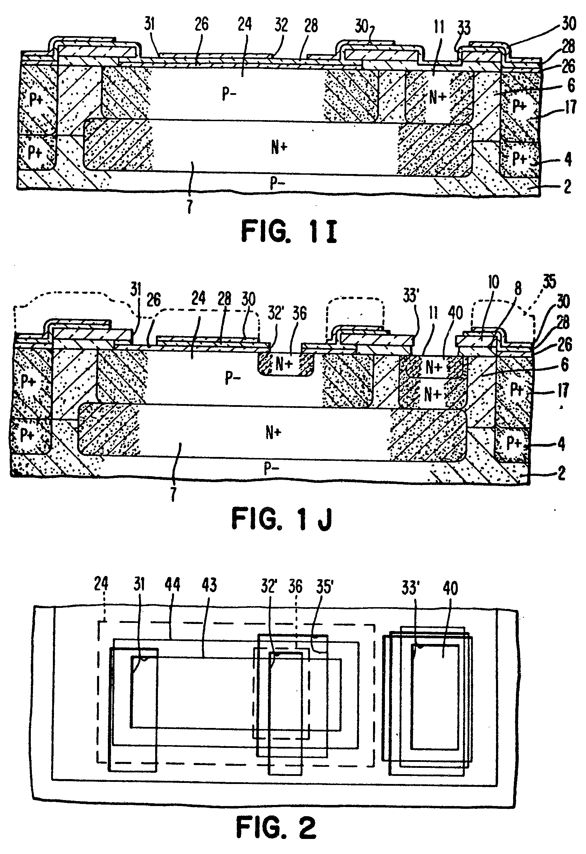

Insbesondere zeigt Fig. 1A einen teilweise fertiggestellten bipolaren Transistor, der nach bisher üblichen Verfahren hergestellt worden ist. Eine $N^+$-leitende vergrabene Schicht 7 liegt teilweise in einem P-leitenden Halbleitersubstrat 2 und teilweise innerhalb einer N-leitenden epitaxialen Schicht 6. Diese Subkollektorzone wird normalerweise dadurch hergestellt, daß man zunächst Arsen als Störelement in das Substrat 2 eindiffundiert und anschließend eine N-leitende Epitaxialschicht 6 bis zu einer Dicke von etwa 2.0 Micrometern darauf aufwachsen läßt.

Das Substrat enthält ferner eine $P^+$-leitende Isolationsdiffusion 4, die die Subkollektorzone 7 umgibt. Die $P^+$-leitende Isolationsdiffusion 4 wird gewöhnlich dadurch hergestellt, daß man vor dem epitaxialen Niederschlag Bor als Störelement in den Halbleiterkörper 2 eindiffundiert, so daß bei der nachfolgenden Herstellung der Epitaxialschicht die $P^+$-leitende Isolationsdiffusion durch Ausdiffusion in die Epitaxialschicht 6 eindringt. Wie bereits erwähnt, sind die Verfahren zum Herstellen der Subkollektorzone und der Isolationsdiffusionszone dem Fachmann allgemein bekannt und lassen sich auf verschiedene Weise durchführen. Die Dicke der Epitaxialschicht 6 kann geringer oder größer sein als 2.0 Micrometer.

Auf der Epitaxialschicht 6 sind drei Maskenschichten 8, 10 und 12 angebracht, die vorzugweise aus Siliciumdioxid, Siliciumnitrid bzw. Siliciumdioxid in dieser Reihenfolge bestehen. Die Maskenschicht 8 wird thermisch auf der Epitaxialschicht 6 bis zu einer Dicke von etwa 140 bis 200 nm aufgewachsen. Die Siliciumnitridschicht 10 kann durch chemischen Niederschlag aus der Dampfphase bis zu einer Dicke zwischen 50 und 150 nm niedergeschlagen werden. Die Maskenschicht 10 kann stattdessen auch aus Silicium-Oxinitrid bestehen. Die Maskenschicht 12 besteht aus chemisch aus der Dampfphase niedergeschlagenem Siliciumdioxid. Diese Siliciumdioxidschicht 12 hat lediglich die Aufgabe, die Nitridschicht 10 zu maskieren, da Ätzmittel, wie zum Beispiel heiße Phosphorsäure, die Siliciumnitrid angreift, auch normale Fotolacke angreift. Anstelle der durch chemischen Niederschlag aus der Dampfphase aufgebrachten Schicht 12 kann diese durch eine durch Kathodenzerstäubung aufgebrachte Siliciumoxidschicht oder andere bekannte Masken ersetzt werden. Andererseits kann die Maskenschicht 12 auch ganz weggelassen werden, wenn das Ätzen als Plasmaätzen durchgeführt wird. Diese Art von Ätzen wird allgemein als reaktives Ionen- oder Plasmaätzen bezeichnet. Beispielsweise läßt sich die Nitridschicht 10 unter Verwendung einer Mischung aus gasförmigem $CF_4$ und $O_2$ in einem Plasmasystem ätzen, indem man den AZ135OH-Fotolack als eine Maske benutzt.

Gemäß Fig. 1B werden unter Verwendung einer Maske, die die verschiedenen Zonen in dem Transistor begrenzt, Öffnungen in die Siliciumdioxidschicht 12 geätzt. In der Darstellung werden die Basiszone, die Anschlußzone für die Subkollektorzone und die Isolationszonen durch die Maske definiert. Andere Zonen, wei zum Beispiel Schottky-Sperrschichtdioden und Widerstände können durch die gleiche Maske an benachbarten Stellen in der Epitaxialschicht 6 definiert werden. Die Schottky-Sperrschichtdiode und der Widerstand, die mit dem Transistor gemeinsam hergestellt werden können, sind nicht gezeigt. Ihre Herstellung läuft jedoch mit den gleichen Verfahrensschritten ab, wie die Bildung der Anschlußzone 11 für den Subkollektor, die beschrieben werden wird.

Die die Dimensionen festlegende Maske, die die verschiedenen Zonen begrenzt, besteht im allgemeinen aus einem Fotolack, wie zum Beispiel AZ135OJ der Firma Shipley, der in der üblichen Weise belichtet und entwickelt wird. Die pyrolitisch niedergeschlagene Siliciumdioxidschicht 12 kann mittels einer Lösung einer in Ammoniumfluorid gepufferten Flußsäure geätzt werden, wobei dieses Ätzmittel Siliciumnitrid im wesentlichen nicht angreift. Die in den Öffnungen der Siliciumdioxidschicht 12 freiliegenden Bereiche der Nitridschicht 10 werden dann in heißer Phosphorsäure oder in jedem anderen Ätzmittel abgeätzt, das Siliciumdioxid nicht angreift. Während dieses Ätzverfahrensschrittes werden die den Subkollektor und die Isolationszone trennenden Bereiche durch den Fotolack maskiert. Somit werden bei diesem Verfahrensschritt bestimmte Zonen in der Siliciumdioxidshicht 12 definiert.

Anschließend wird eine aus Fotolack bestehende Sperrmaske zum Herstellen einer Öffnung für den Subkollektor anschluß sowie einer Öffnung für den Widerstandsbereich (nicht gezeigt) benutzt. Die Lage der Subkollektorzone und der Widerstandsbereiche wird ferner dadurch definiert, daß man die freiliegenden Bereiche der Siliziumnitridschicht 10 in heißer Phosphorsäure oder jedem anderen Ätzmittel ätzt, das Siliciumdioxid nicht angreift. Nachdem diese Öffnungen in der Siliciumnitridschicht 10 hergestellt sind, wird das Halbleiterplättchen einem Ätzmittel ausgesetzt, das die Bereiche der Oxidschicht 8 angreift, die in den Öffnungen der Siliciumnitridschicht 10 freiliegen. Zum Ätzen der Siliciumdioxidschicht 8 wird vorzugsweise in Ammoniumfluorid gepufferte Flußsäure benutzt. Andere Zonen der Siliciumnitridschicht 10 und der Siliciumdioxidschicht 8 sind durch die aus Fotolack bestehende Sperrmaske geschützt und werden nicht angegriffen. Dann wird die Fotolackschicht vollständig abgezogen und es wird durch die Öffnung zur Bildung der durchgehenden Verbindung 11 nach dem Subkollektor eine Diffusion durchgeführt. Der Dotierungsstoff für den Subkollektor ist gewöhnlich Phosphor, obgleich auch Arsen oder ein anderes Störelement der Gruppe V verwendet werden kann. Der Phosphor wird bei einer Temperatur von 1000°C in einer oxidierenden Atmosphäre eingetrieben, wodurch eine Oxidschicht bis zu einer Dicke von etwa 140 nm aufwächst, wie dies Fig. 1D zeigt. Zu diesem Zeitpunkt ist die pyrolitisch niedergeschlagene Oxidschicht 12 abgezogen und der $N^+$-leitende Anschlußbereich 11 für die Subkollektorzone und der zusätzliche Widerstandsbereich (nicht gezeigt) sind fertiggestellt. Das Substrat ist dabei vollstädig mit einer thermisch aufgewachsenen Siliciumdioxidschicht 8 überzogen und die verbleibenden, noch herzustellenden Zonen sind durch die Siliciumnitridschicht 10 definiert.

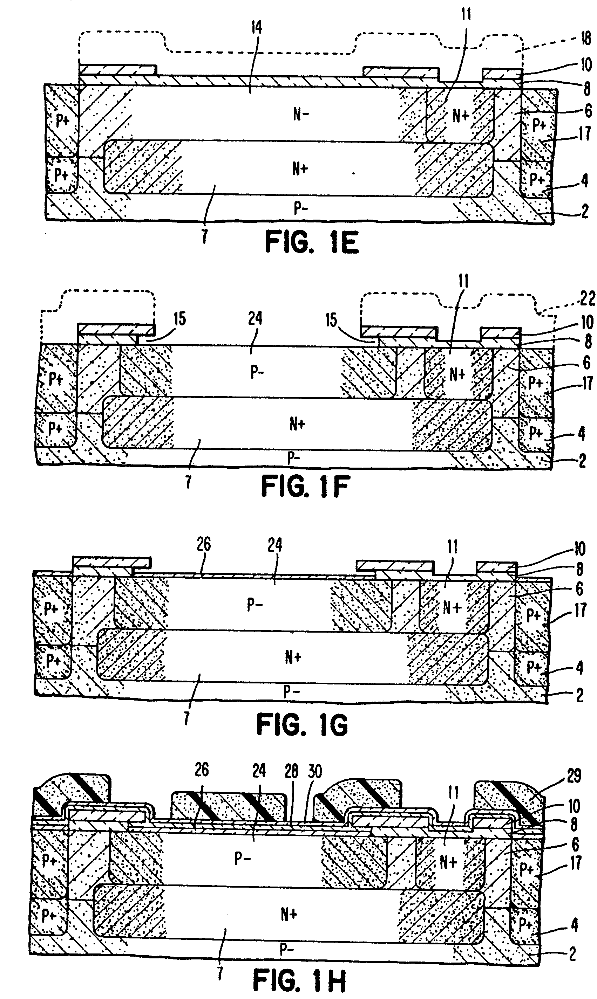

Bei diesem Stand des Verfahrens wird durch die Siliciumdioxidschicht 8 hindurch eine Öffnung nach der $P^+$-leitenden Zone 17 hergestellt. Die thermisch aufgewachsene Siliciumdioxidschicht über der N-leitenden Zone 14, die durchgehende Anschlußzone 11 und der Widerstandsbereich sind durch die Sperrmaske 18 geschützt. Anschließend wird eine Diffusion von P-leitendem Material, etwa Bor, in dem freiliegenden Bereich durchgeführt, wodurch die $P^+$-leitende Isolationszone 17 gemaß Fig. 1E gebildet wird.

Im nächsten, in Fig. 1F dargestellten Verfahrensschritt wird eine andere Sperrmaske 22 zum Schutz aller Bereiche des Substrats mit Ausnahme der Zone 14 eingesetzt. Dann wird in der Siliciumdioxidschicht 8 eine Öffnung zum Freilegen der Zone 14 hergestellt. Dieses Ätzverfahren ergibt eine Unterschneidung der Siliciumnitridschicht 10 in den Bereichen 15, d. h. daß ein schmales aus Siliciumdioxid bestehende Band unter der Siliciumnitridschicht entfernt wird, so daß ein Überhang entsteht. Diese Unterschneidung ist für die vorliegende Erfindung kritisch und muß genau überwacht werden, wenn die Siliciumdioxidschicht 8 in gepufferter Flußsäure geätzt wird. Die Ätzgeschwindigkeit von thermisch aufgewachsenem Siliciumdioxid in 7:1 gepufferter Flußsäure bei 31°C beträgt etwa 160 nm je Minute. Wenn daher die Öffnungen nach der Zone 14 hergestellt sind, dann wird das Ätzen bis zum Erzielen einer Unterschneidung von etwa 0.6 bis 0.7 Micrometern fortgesetzt. Andererseits könnte das Ätzen auch mittels einer Plasmaätzung für eine genau überwachte Unterschneidung durchgeführt werden.

Dann wird die P-leitende Basiszone 24 in die $N^-$-leitende Epitaxialzone 6 eindiffundiert. Die Basiszone kann auch durch Ionen-Implantation und anschließendes Eintreiben hergestellt werden, wobei man im wesentlichen die gleiche Art von Basiszone erhält. Somit ist die Diffusionsöffnung, die durch die thermisch aufgewachsene Siliciumdioxidschicht 8 definiert, ist, auf jeder Seite um mindestens 0.6 bis 0.7 Micrometer weiter, als die in der Siliciumnitridschicht 10 gebildete Öffnung.

Bei einem typischen Basis-Diffusionsverfahren wird $BBr_3$ in einer aus trockenem Sauerstoff und Argon bestehenden Atmosphäre bei etwa 875°C als Borsilikatglas bis zu einer Dicke von etwa 40 nm niedergeschlagen. Nach der Diffusion wird das Glas zur Entfernung der gesamten Glasschicht in gepufferter Flußsäure abgeätzt und die Basis wird durch übliches Eintreiben und ein Reoxidationsverfahren gebildet, das bei 925°C in Wasserdampf und Sauerstoff abläuft. Dadurch bildet sich eine Schicht 26 aus thermisch aufgewachsenem Siliciumoxid mit einer Stärke von 80 nm über der Basiszone und den Isolationsbereichen, wie dies Fig. 1G zeigt. Die Oxidschicht 26 bildet sich außerdem unter dem aus Siliciumnitrid bestehenden Überhang.

Zu diesem Zeitpunkt sei darauf hingewiesen, daß die P-leitenden Zonen 17 und 24 gleichzeitig gebildet werden können, was natürlich von den Verfahrenparametern abhängt.

In dem nächsten in Fig. 1H dargestellten Verfahrensschritt werden nacheinander Schichten aus Siliciumnitrid und Siliciumdioxid, die mit 28 bzw. 30 bezeichnet sind, enteder durch chemischen Neiderschlag aus der Dampfphase oder durch Kathodenzerstäubung aufgebracht. Die Dicke der Schicht 28 und 30 beträgt vorzugsweise etwa 100 nm. Die Schicht 30 dient während eines Naßätzverfahrens mit heißer Phosphorsäure lediglich als Maske. für die Siliciumnitridschicht 28. Durch diesen Neiderschlag wird der Überhang unterhalb der Siliciumnitridschicht an der Unterschneidungszone 15 vollständig ausgefüllt. Die Zusammensetzung und Dicke der hier niedergeschlagenen Materialien kann dabei anders sein. Beispielsweise könnte, was jedoch weniger wünschenswert ist, die Basisoxidschicht 26 dicker gemacht werden, so daß dadurch die Unterschneidungszone 15 vollständig ausgefüllt wird, ohne daß dafür noch Siliciumnitrid benötigt würde. Ferner könnte Siliciumnitrid durch Silicium-Oxinitrid oder ein anderes Maskenmaterial ersetzt werden. In der Tat könnte die Schicht 28 aus Silicium-Oxinitrid und die Schicht 10 aus Siliciumnitrid bestehen oder umgekehrt. Die wichtige Überlegung hierbei ist, daß die Dicke der Maskenschicht am Umfang der Basisöffnung größer ist, als die Dicke der Maskenschicht innerhalb der Öffnung, wobei beide mit dem gleichen Ätzmittel ätzbar sind. Auf diese Weise können Sperrmasken für die Definition der Emitterzone und anderer mit Störelementen dotierter Zonen verwendet werden, ohne die Schwierigkeit, bis auf die geschützten Flächen des Substrats hinab ätzen zu müssen.

Anschließend wird eine einzelne Maske 29 zur Bildung von Öffnungen auf der Oxidschicht 30 hergestelt zur Bildung des Basiskontakts und der Emitterzonen über der Basiszone 24. Die hier dargestellte Ausführungsform zeigt eine einzige für Basiskontakt bestimmte Öffnung. Es können aber auch zwei oder mehrere Kontakte auf jeder Seite des Emitters gebildet werden. Die Breite des Emitters innerhalb der Basiszone 24 wird durch das neue Verfahren sorgfältig gesteuert. Dies wird durch die vollkommen ausgefüllte Unterschneidung 15 und die doppelten Maskenschichten am Umfang der Basisöffnung ermöglicht. Da dadurch die Emmitteröffnung ganz exakt definiert ist, verhindert diese doppelte Maskenschicht, daß der Emitter zu nahe in Richtung auf den Umfang der Basiszone 24 nach der Seite diffundiert.

Wie Fig. 1I zeigt, wird die Siliciumdioxidschicht 30 dann zum Herstellen der öffnungen 31, 32 und 33 durch die Sperrmaske 29 hindurch geätzt. Ebenso wird das Siliciumnitrid an den freiliegenden Bereichen abgeätzt, wobei die Siliciumdioxidschicht 30 als eine Maske benutzt wird.

Eine zweite Sperrmaske 35, die die Zone 31 gegen Ätzen schützt, wird dann zum Abätzen der thermisch aufgewachsenen Siliciumdioxidschicht 26 in den in Fig. 1J gezeigten Öffnungen 32 und 33 benutzt. Zum Freilegen der Öffnungen 32' und 33' bis zur Oberfläche der Schicht 6 wird ein übliches Ätzverfahren mit gepufferter Flußsäure oder Plasmaätzen eingesetzt. Die Emmiterzone wird dann in üblicher Weise, beispielsweise durch die Diffusion von Arsen gebildet. In gleicher Weise wird die Leitfähigkeit in dem Verbindungsbereich 11 durch Arsendiffusion im Bereich 40 erhöht.

Eine Öffnung für eine Schottky-Sperrschichtdiode kann während dieses Verfahrensschritts bis zur epitaxialen Schicht 6 hinunter in einem Bereich, der hier nicht gezeigt ist, hergestellt werden.

Der Kontakt mit der Basiszone kann dadurch hergestellt werden, daß man die Öffnungen 32 und 33 mit einer Sperrmaske verschließt, während der innerhalb der Öffnung 31 freiliegende Teil der Siliciumdioxidschicht 26 frei bleibt. Es kann hierbei erwünscht sein, eine dünne abschirmende Oxidschicht mit einer Stärke von etwa 10 nm im Bereich von Emitterund Subkollektorzonen niederzuschlagen, um dadurch diese Zonen gegen eine Verunreinigung durch den Fotolak zu schützen. Dann wird das Oxid in der Öffnung 31 entfernt, wodurch der Basiskontaktbereich für eine nachfolgende Metallisierung (nicht gezeigt) freigelegt wird.

In Fig. 2 ist eine Draufsicht auf den Transistor bei dem in Fig. 1J dargestellten Verfahrensstand gezeigt, wobei die automatische Ausrichtung der Emmitterzone 36 innerhalb der Basiszone 24 zu erkennen ist. Dabei wird immer wegen der zuvor besprochenen Unterschneidung ein ausgewählter Abstand zwischen der Kante der Emitterzone 36 und der Kante der Basiszone 34 vorhanden sein. Beim derzeitigen Stand der Technik ist diese Unterschneidung mindestens 0.7 Micrometer breit.

Die durch die Siliciumnitridschicht 10 definierte Maske für die Basiszone und die durch die Oxidschicht 8 in Fig. 1F definierte Öffnung für die Basisdiffusion sind durch die Bezugszeichen 43 und 44 bezeichnet. Die Maske für die Emmiterzone ist durch die Öffnung 32' definiert und die durch die Sperrmaske 35 definierte Öffnung ist durch 35' gekennzeichnet. Dabei sind beide dieser Masken absichtlich nicht richtig miteinander ausgerichtet dargestellt, doch hat dies bei dem neuartigen Verfahren gemäß der Erfindung keine Auswirkung auf die Ausrichtung der Emitterzone. Es sei weiter darauf hingewiesen, daß die Emittermaske 32' die Basismaske 43 überlappt, was zeigt,, welche Toleranzen bei der Maskengestaltung bei dem neuen Verfahren möglich sind.

**Patentransprüche**

1. Verfahren zum Herstellen einer mit einem Störelement dotierten Zone innerhalb eines gewünschten Bereichs der Oberfläche eines Halbleitersubstrats durch Bilden einer aus einer unteren (8) und einer oberen (10) Schicht bestehenden ersten Maskenschicht (8, 10), deren Materialien selektiv ätzbar sind, und durch Ätzen einer ersten den vorerwähnten Bereich definierenden Öffnung in der ersten Maskenschicht in der Weise, daß ein Teil der oberen Schicht (10) einen Überhang (15) über der unteren Schicht (8) bildet, gekennzeichnet durch folgende weitere Verfahrensschritte:

Bilden einer zweiten Maskenschicht (26, 28), die eine Schicht eines Materials einschließt, das mit dem gleichen Ätzmittel ätzbar ist, wie die obere Schicht (10), so daß der Überhang mindestens teilweise ausgefüllt ist und das gesamte vorerwähnte mit dem gleichen Ätzmittel ätzbare Material innerhalb der Öffnung dünner ist als an ihrem Umfang, Ätzen einer zweiten Öffnung (32) innerhalb der ersten Öffnung mittels einer Sperrmaske durch die sweite Maskenschicht (26, 28) hindurch, und Einführen eines Störelementes durch die zweite Öffnung (32) zur Bildung der dotierten Zone (36).

2. Verfahren nach Anspruch 1, dadurch gekennzeichnet, daß während der Bildung der mit einem Störelement dotierten Zone (36) eine andere mit einem Störelement dotierte Zone (40) des gleichen Leitungstyps in einem Bereich des Substrats außerhalb der ersten Öffnung gebildet wird.

3. Verfahren nach Anspruch 1, dadurch gekennzeichnet, daß beim Erzeugen der zweiten Maskenschicht (26, 28) der Überhand (15) durch die untere Schicht alleine ausgefüllt wird.

4. Verfahren nach Anspruch 1, dadurch gekennzeichnet, daß beim Erzeugen der zweiten Maskenschicht der Überhang durch untere und die obere Schicht (26, 28) ausgefüllt wird.

5. Verfahren nach den Ansprüchen 1 bis 4, dadurch gekennzeichnet, daß als Material für die untere Schicht (8) der ersten Maskenschicht Siliciumdioxid und als Material der oberen Schicht (10) Siliciumnitrid oder Siliciumoxinitrid verwendet wird.

6. Verfahren nach den Ansprüchen 1 bis 4, dadurch gekennzeichnet, daß in der zweiten Maskenschicht für das mit dem gleichen Ätzmittel ätzbare Material Siliciumnitrid oder Siliciumoxinitrid verwendet wird.

7. Verfahren nach Anspruch 1, dadurch gekennzeichnet, daß bei der Herstellung der zweiten Maskenschicht zunächst thermisch auf der freiliegenden Substratoberfläche eine Siliciumdioxidschicht (26) gebildet wird, die den Überhang (15) teilweise ausfüllt.

8. Verfahren nach Anspruch 1, dadurch gekennzeichnet, daß als Material für die untere Schicht (8) der ersten Maskenschicht Siliciumdioxid und als Material für die obere Schicht (10) Silicumnitrid verwendet wird und daß als Materialien für die zweite Maskenschicht unten Silidiumdioxid und oben Siliciumnitrid verwendet wird.

9. Verfahren nach Anspruch 8, dadurch gekennzeichnet, daß zur Bestimmung eines zweiten Bereichs innerhalb der ersten Öffnung während des Ätzens der zweiten Öffnung durch die Siliciumnitridschicht eine dritte Öffnung durch die Siliciumnitridschicht geätzt wird, während andere Bereiche der Maskenschicht geschützt werden,

daß dann nach dem Ätzen der Siliciumdioxidschicht die dritte Öffnung durch Ätzen der Siliciumdioxidschicht in der zweiten Öffnung hergestellt wird, während gleichzeitig andere Teile der Maskenschichten und die zweite Öffnung gegen Ätzen geschützt werden.

## Revendications

1. Procédé pour fabriquer une région dopée à l'intérieur d'une région prédéterminée de la surface d'un substrat semiconducteur en produisant une premierè couche de masquage (8, 10) composée d'une couche inférieure (8) et d'une couche supérieure (10) dont les matériaux peuvent être décapés sélectivement, et en décapant une première fenêtre définissant la région mentionnée cidessus dans la première couche de masquage de sorte qu'une partie de la couche supérieure (10) forme un surplomb (15) au-dessus de la couche inférieure (8), caractérisé en outre par les étapes de procédé suivantes:

formation d'une seconde couche de masquage (26,28) comportant une couche d'un matériau qui peut être décapé avec le même décapant que la couche supérieure (10) de sorte que le surplomb soit comblé, au moins partiellement, et que la totalité du matériau mentionné ci-dessus qui peut être décapé avec le même décapant soit plus mince à l'intérieur de la fenêtre qu'à son pourtour,

dècapage d'une seconde fenêtre (32) à l'intérieur de la première fenêtre au moyen d'un masque de blocage à travers la seconde couche de masquage (26, 28) et introduction d'un élément de dopage à travers la seconde fenêtre (32) pour former la région dopée (36).

2. Procédé selon la revendication 1 caractérisé en ce que, pendant la formation de la région (36) dopée, une autre région (40) dopée avec une impureté du même de conductivité est formée dans une région du substrat à l'extérieur de la première fenêtre.

3. Procédé selon la revendication 1 caractérisé en ce que, pendant la formation de la seconde couche de masquage (26, 28), le surplomb (15) est uniquement comblé par la couche inférieure.

4. Procédé selon la revendication 1 caractérisé en ce que, pendant la formation de la seconde couche de masquage, le surplomb est comblé par les couches inférieure et supérieure (26, 28).

5. Procédé selon l'une des revendications 1 à 4 caractérisé en ce que le matériau utilisé pour la couche inférieure (8) de la première couche de masquage est le dioxyde de silicium, et le matériau utilisé pour la couche supérieure (10) est le nitrure de silicium ou l'oxynitrure de silicium.

7. Procédé selon l'une des revendications 1 à 4 caractérisé en ce que dans la seconde couche de masquage on utilise comme matériau pouvant être décapé avec le même décapant du nitrure de silicium ou de l'oxynitrure de silicium.

7. Procédé selon la revendication 1 caractérisé en ce que, pour obtenir la seconde couche de masquage, on forme d'abord par croissance thermique sur la surface exposée du substrat une couche de dioxyde de silicium (26) qui comble partiellement le surplomb (15).

8. Procédé selon la revendication 1 caractérisé en ce que le matériau utilisé pour la couche inférieure (8) de la première couche de masquage est le dioxyde de silicium et le materiau utilisé pour couche supérieure (10) est le nitrure de silicium, et que les matériaux utilisés pour la seconde couche de masquage sont le dioxyde de silicium dans la partie inférieure de la couche et le nitrure de silicium dans sa partie supérieure.

9. Procédé selon la revendication 8 caractérisé en ce que, pour la définition d'une seconde région à l'intérieur de la première fenêtre, on décape, durant le processus de décapage de la seconde fenêtre à travers la couche de nitrure de silicium, une troisième fenêtre à travers la couche de nitrure de silicium alors que d'autres parties de la couche de masquage sont protégées, qu'après dècapage de la couche de dioxyde de silicium on obtient la troisième fenêtre par décapage de la couche de dioxyde de silicium dans la seconde fenêtre tandis qu'en même temps d'autres parties des couches de masquage et la seconde fenêtre sont protégées contre le décapage.

## Claims

1. Method of making a region doped with an impurity within a predetermined region of the surface of a semiconductor substrate, by forming a first masking layer (8, 10) consisting of a lower (8) and an upper (10) layer whose materials are selectively etchable, and by etching a first window defining the above mentioned area in the first masking layer in such a manner that a portion of the upper layer (10) forms an overhang (15) over the lower layer (8), characterized by the following further process steps: forming a second masking layer (26, 28) which includes a layer of a material which is etchable with the same etchant as the upper layer (10) so that the overhang is filled in at least partly, and the entire material mentioned above etchable with the same etchant is thinner within the window than at its periphery, etching a second window (32) within the first window through the second masking layer (26, 28) by means of a blocking mask, and introducing an impurity through the second window to form the impurity region (36).

2. Method as claimed in claim 1, characterized in that during the forming of the region (36) doped with an impurity another impurity-doped region (40) of the same conductivity is formed in a region of the substrate outside the first window.

3. Method as claimed in claim 1, characterized, in that in the forming of the second masking layer (26, 28) the overhang (15) is filled in by the lower layer exclusively.

4. Method as claimed in claim 1, characterized in that in the forming of the second masking layer the overhang is filled in by the lower and the upper layer (26, 28).

5. Method as claimed in claims 1 to 4, characterized in that as material for the lower layer (8) of the first masking layer silicon dioxide is used, and as material for the upper layer (10) silicon nitride or silicon oxynitride is used.

6. Method as claimed in claims 1 to 4, characterized in that in the second masking layer for the material etchable with the same etchant silicon nitride or silicon oxynitride is used.

7. Method as claimed in claim 1, characterized in that in the forming of the second masking layer a silicon dioxide layer (26) is thermally grown on the exposed substrate surface, said layer partially filling in the overhang (15).

8. Method as claimed in claim 1, characterized in that as a material for the lower layer (8) of the first masking layer silicon dioxide is used, and as material for the upper layer (10) silicon nitride is used, and that as materials for the second masking layer a lower silicon dioxide layer and an upper silicon nitride layer is used.

9. Method as claimed in claim 8, characterized in that for defining a second region within the first window during etching of the second window through the silicon nitride layer a third window is etched through the silicon nitride layer while protecting other portions of the masking layer, that after the etching of the silicon dioxide layer the third window is made by etching the silicon dioxide layer in the second window while simultaneously protecting against etching other portions of the masking layers, and the second window.

FIG. 1A

FIG. 1B

FIG. 1C

FIG. 1D

FIG. 1E

FIG. 1F

FIG. 1G

FIG. 1H

FIG. 1 I

FIG. 1 J

FIG. 2

3